# EUROPEAN PATENT APPLICATION

(11) **EP 2 228 833 A2**
(43) Date of publication of application: **15.09.2010**
(21) Application number: 09011440.6
(22) Date of filing: 07.09.2009
(51) Int. Cl.: H01L 31/052

(54) **Maintenance-friendly concentrated solar power module**

(30) Priority: 10.03.2009 TW 98107628
(71) Applicant: Everphoton Energy Corporation, Tapei (TW)
(72) Inventor: Chen, Yee Lee, Neihu Dist. Tapei 11493 (TW); Tsai, Chong Han, Neihu Dist. Tapei 11493 (TW)
(74) Representative: Epping - Hermann - Fischer

(57) **Abstract**

A concentrated solar power module including a lens, a light shield plate, a solar-powered electricity generator, and a heat-dissipating element is provided. The lens allows sunlight to be focused to a specific area and is coated with a self-cleaning material. The light shield plate is provided beneath the lens and formed with an opening for selectively admitting the sunlight focused. The solar-powered electricity generator is formed beneath the opening for receiving the sunlight penetrating the opening. The solar-powered electricity generator includes a solar cell and a secondary light transmissive member coated with a self-cleaning material and configured to hermetically seal the solar cell. The heat-dissipating element is mounted on the solar-powered electricity generator to dissipate heat generated by the solar-powered electricity generator. With the secondary light transmissive member being coated with the self-cleaning material, the concentrated solar power module is free of water condensation-induced degradation, easy to clean, and contaminant-proof.

## Description

### FIELD OF THE INVENTION

The present invention relates to solar power modules, and more particularly, to a concentrated solar power module comprising a lens, a light shield plate, and a solar-powered electricity generator.

### BACKGROUND OF THE INVENTION

Solar cells typically occupy a considerable area in order to receive as much solar energy as possible. Concentrated solar power devices reduce the area occupied by solar cells of the concentrated solar power devices, by focusing sunlight and then transmitting the focused sunlight to the solar cells, resulting in a significant decrease in production costs. Therefore, concentrated solar power devices are commonly used in the solar industry.

However, the above-mentioned concentrated solar power devices do have drawbacks. For example, in the nighttime, moisture inside the frames of the concentrated solar power devices condenses into dew, and the dew deteriorates the solar cells. Compared to solar cells made of crystallized silicon semiconductors, solar cells made of Group III - V compounds such as InGaP/InGaAs/Ge degrade even faster due to the activity thereof.

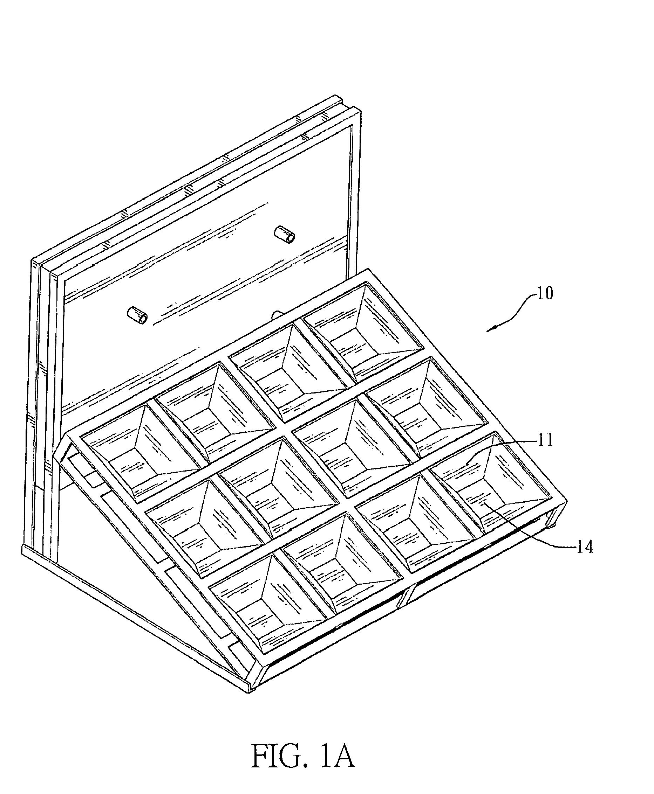

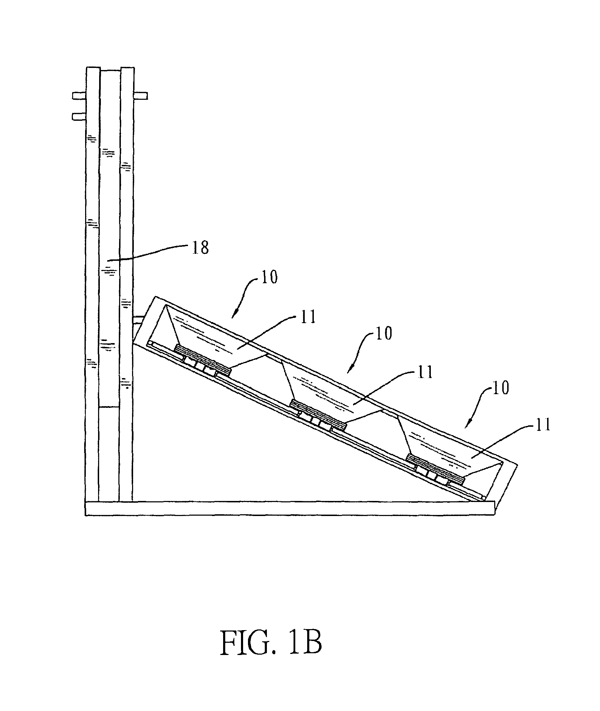

According to Taiwanese Utility Model Patent No. M248025, a solar power application for electric power generation and heat collecting is disclosed. FIGs 1A and 1B are perspective and side diagrams, respectively, showing a solar power application according to an aspect of this patent, wherein the electric power generating module 10 comprises a thermal conducting plate, solar power generating components 14, a reflective concentrated shield 11, and a case equipped with a circulating heat exchanger case. While the solar power application contains two or more electric power generating modules 10, they are adjacent to each other and are fixed in position by a carrier 18, allowing the electric power generating modules 10 to be titled so as to increase their effective duration of exposure to sunlight. The solar power generating components 14 are electrically connected to each other in series, and can transform light energy into direct current. Further, with the reflective concentrated shield 11, sunlight can be focused and directed to the solar power generating components 14 to enhance the efficiency of electric power generation. During electrical power generation, the solar power generating components 14 produce waste heat. The waste heat is transferred to the circulating heat exchanger case through the thermal conducting plate and the heat conductive fins in the bottom for heat exchange and for heating up water.

However, the above-mentioned solar power application has its own drawbacks. The solar power generating components 14 are directly exposed to the air and seldom shut down, and thus dew occurs to the solar power generating components 14 and contributes to deterioration thereof. In addition, powder, dust or other contaminants can accumulate in the solar power generating components 14, thereby affecting the efficiency of receipt of light and photovoltaic transformation. Moreover, maintaining and cleaning the solar power generating components 14 incurs high costs and may damage the solar power generating components 14 and deteriorate the functionality thereof.

Consequently, an inventor put forth a solar power generating component hermetically sealed and thereby free of water condensation-induced deterioration, easy to clean, and contaminant-proof.

Taiwanese Patent No. 200805681 is directed to a solar power device and a method of fabricating the same. FIGs 2A and 2B are side and top diagrams, respectively, showing a solar power generator 20 according to an aspect of the patent, wherein the solar power generator 20 comprises a generator, an intelligent power supply controller, a plurality of solar power modules 24, and a plurality of optical lens sets 21. The generator is a standard automatic generator, and the intelligent power supply controller is connected between the generator and the solar power modules 24 for switching control of the generator. The solar power modules 24 each comprise a gallium arsenide solar module chipset (not shown) for transforming received light energy into electrical energy and transferring the electrical energy to the intelligent power supply controller. The optical lens sets 21 are installed on the solar power generator, each substantively shaped like a casing for allegedly providing hermetical sealing, and allegedly configured to hermetically seal the solar power modules 24, respectively, in an attempt to overcome the above drawbacks of the prior art.

Taiwanese Patent No. 200805681 allegedly taught hermetically sealing the solar power modules 24 by the optical lens sets 21, respectively, but the risk of permeation of water or moisture into the solar power modules 24 remains unabated indeed. More badly, owing to diurnal temperature variation, water trapped in the substantively enclosed space provided within the solar power modules 24 undergoes phase changes, and pressure inside the solar power modules 24 may even vary, thereby damaging the solar power modules 24 eventually. Further, even if the solar power modules 24 were hermetically sealed by the optical lens sets 21, respectively, the outer surfaces of the optical lens sets 21 still would be difficult to clean and susceptible to deposition of contaminants.

Therefore it is imperative to provide a lens and solar cells free of flaws, such as electronic component degradation due to condensation, difficulty in cleaning, and contaminant deposition.

### SUMMARY OF THE INVENTION

In view of the above-mentioned drawbacks in the prior art, the present invention provides a concentrated solar power module with an improved light concentrated function for avoiding problems, such as condensation, uneven pressure, difficulty in cleaning, and contaminant deposition. Hence, the concentrated solar power module is maintenance-friendly, penetrable by sunlight, and durable.

To this end, the present invention provides a concentrated solar power module comprising: a lens used under the sun for focusing a plurality of light rays, wherein the lens is coated with a self-cleaning material; a light shield plate coupled to the lens and yet spaced apart from the lens by a predetermined distance, wherein the light shield plate is formed with an opening selectively penetratable by a plurality of light rays thus concentrated by the lens; a solar-powered electricity generator coupled to the light shield plate and yet spaced apart from the light shield plate by a predetermined distance, the solar-powered electricity generator comprising a base, a secondary light transmissive member mounted on the base and coated with a self-cleaning material, and a solar cell mounted on the base, wherein an enclosed space is defined by the secondary light transmissive member and the base so as for the solar cell to be accommodated in the enclosed space in a hermetically sealed manner; and a heat-dissipating element coupled to the solar-powered electricity generator for dissipating heat generated by the solar-powered electricity generator.

The lens used in the concentrated solar power module is a Fresnel lens, for example. The self-cleaning material is a metal oxide or a nanomaterial. The metal oxide enables a photocatalyst reaction in the presence of ultraviolet (UV) of sunlight. The metal oxide is selected from the group consisting of titanium dioxide, tin oxide, tungsten trioxide, zinc oxide, and zirconium oxide. When coated on the lens and the secondary light transmissive member, the nanomaterial prevents water and dust from adhering to the lens and the secondary light transmissive member. For example, the secondary light transmissive member coated with titanium dioxide exhibits hydrophilic characteristic whenever the solar-powered electricity generator is exposed to UV light. As a result, it can prevent dust from attaching to the surface of the solar-powered electricity generator. Furthermore, the titanium dioxide is able to initiate a photocatalyst reaction to decompose bacteria, organic or inorganic material, so that the surface of the solar-powered electricity generator (i.e. the secondary light transmissive member) stays clean longer and is easy to clean and maintain.

The concentrated solar power module further comprises at least a frame for coupling the lens, the light shield plate and the solar-powered electricity generator together so as for internal components of the concentrated solar power module to communicate with the exterior thereof so as to reduce wind resistance and vibration of the concentrated solar power module.

The concentrated solar power module further comprises a diode and a metal housing mounted on the base. The diode is electrically connected to the solar cell. The diode is a bypass diode or a blocking diode, depending on whether the solar-powered electricity generators or the solar cells are connected in series or in parallel.

The concentrated solar power module further comprises a cleaning mechanism installed beside the lens for cleansing the surface thereof.

In the nutshell, the present invention provides a concentrated solar power module with an improved structure which can avoid problems such as condensation, uneven pressure, difficulty in cleaning, contaminant deposition and so on. Moreover, the concentrated solar power module allows a maintenance-friendly system with better penetrability for light, thereby extending its product lifetime.

### BRIEF DESCRIPTION OF DRAWINGS

FIGs. 1A and 1B provide perspective and side diagrams, respectively, showing a solar power application according to an aspect of a prior art;

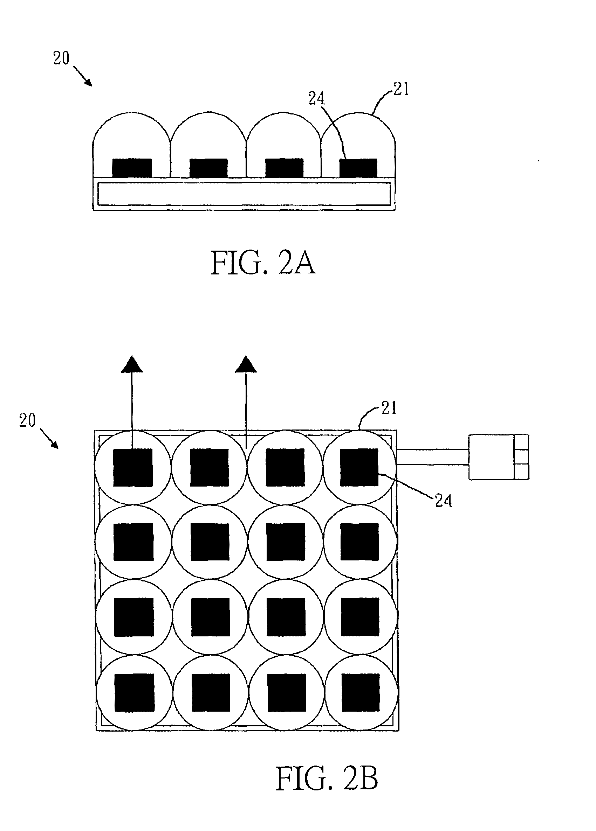

FIGs. 2A and 2B provide side and top diagrams, respectively, showing a solar power generator according to an aspect of a prior art;
FIGs. 3A and 3B are cross-sectional diagrams showing a concentrated solar power module according to an aspect of the present invention; and
FIG. 4 is a cross-sectional diagram showing a concentrated solar power module according to another aspect of the present invention.

### DETAILED DESCRIPTION OF THE PREFERRED EMBODIMENTS

Other features and benefits of the present invention will be clear to those skilled in the art upon reading the following detailed description of illustrative preferred embodiments and in conjunction with the accompanying drawings and the appended claims.

It is to be noted that the following embodiments illustrating a concentrated solar power module coated with a self-cleaning material are not intended to restrict the scope of the present invention, but are provided only for clarification.

The concentrated solar power module provided by the present invention comprises a lens, a light shield plate, a solar-powered electricity generator, a solar cell and a heat-dissipating element to make the concentrated solar power module easy to clean as well as to reduce condensation. The following embodiments are only exemplary descriptions; there may still be other possible modifications.

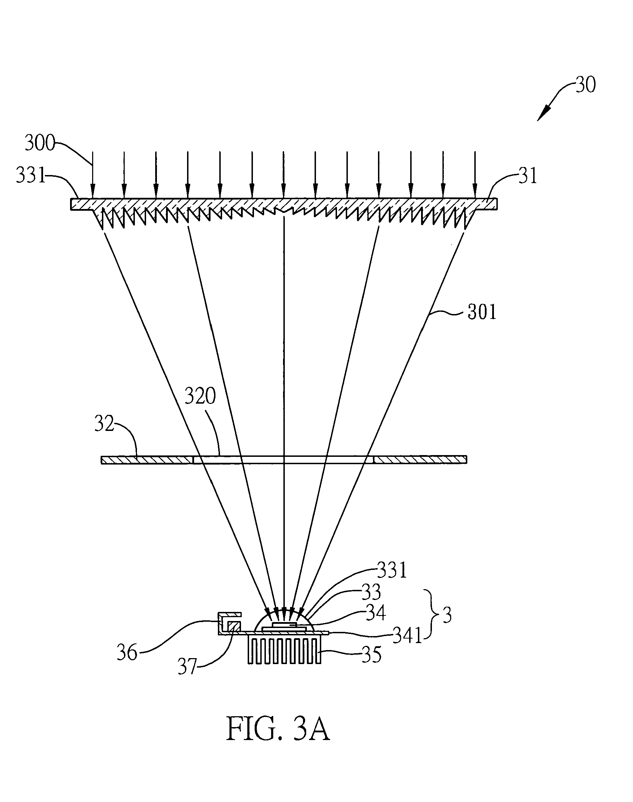

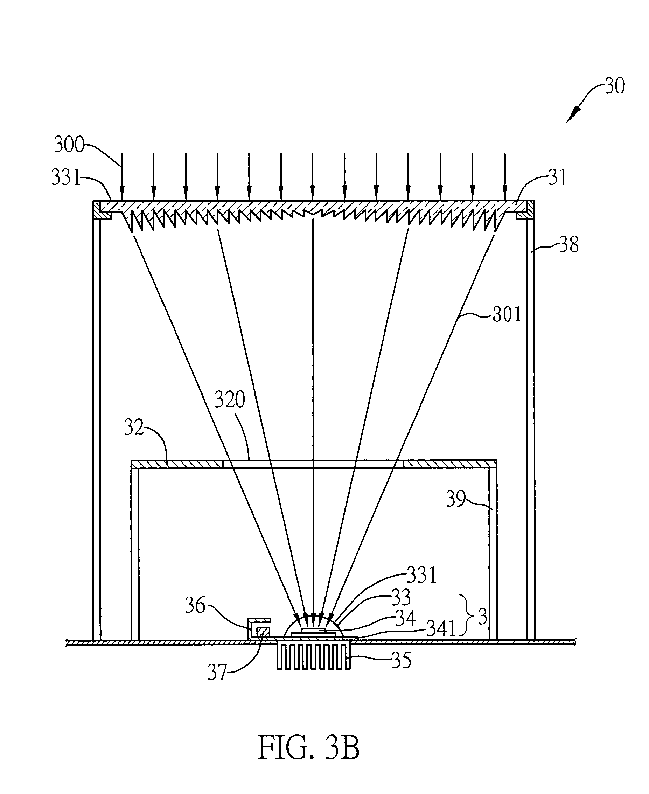

FIGs 3A and 3B are cross-sectional diagrams showing a concentrated solar power module according to an aspect of the present invention. As shown in FIG. 3A, a concentrated solar power module 30 comprises a lens 31, a light shield plate 32, a solar-powered electricity generator, and a heat-dissipating element 35. The lens 31 is coated with a self-cleaning material 331 and configured for exposure to the sun and penetration by a plurality of light rays 300 from the sun so as for the light rays 300 to be focused on a specific spot. The light shield plate 32 is disposed below the lens 31 and spaced apart therefrom by a predetermined distance. The light shield plate 32 is formed with an opening 320 selectively penetratable by a plurality of light rays 301 thus concentrated by the lens 31. The solar-powered electricity generator is disposed below the light shield plate 32, coupled to the light shield plate 32 and yet spaced apart from the light shield plate 32 by a predetermined distance, and configured to collect the light rays 301 having penetrated the opening 320. Specifically speaking, in an embodiment, the light shield plate 32 is provided between the lens 31 and the solar-powered electricity generator, and the opening 320 corresponds in position to the solar-powered electricity generator, allowing the light rays 301 thus concentrated by the lens 31 to penetrate the opening 320 and reach the solar-powered electricity generator so as to be received by a solar cell of the solar-powered electricity generator. The solar-powered electricity generator comprises a base 341, a secondary light transmissive member 33 coupled to the base 341 and coated with the self-cleaning material 331, and a solar cell 34 mounted on the base 341. An enclosed space is defined by the secondary light transmissive member 33 and the base 341 so as for the solar cell 34 to be accommodated in the enclosed space in a hermetically sealed manner. The heat-dissipating element 35 is mounted on the solar-powered electricity generator for dissipating heat generated by the solar-powered electricity generator.

The self-cleaning material 331 coated on the lens 31 and the secondary light transmissive member 33 is a metal oxide. The metal oxide undergoes photocatalysis in the presence of ultraviolet (UV) of sunlight, and is selected from the group consisting of titanium dioxide, tin oxide, tungsten trioxide, zinc oxide, and zirconium oxide. For example, the lens 31 and secondary light transmissive member 33 coated with titanium dioxide are dustless and easy to clean, because titanium dioxide exhibits superhydrophilicity and decomposes dirt by photocatalysis when irradiated by sunlight. Alternatively, the self-cleaning material 331 coated on the lens 31 and the secondary light transmissive member 33 is a nanomaterial. Water and dust do not adhere to the lens 31 and secondary light transmissive member 33 coated with a nanomaterial. The nanomaterial is a paint doped with nano-particles, including a metallic nano-coating in nano-crystalline phase, and an inorganic nano-coating obtained by melting and sintering nano-particles. The nano-particles are made of one selected from the group consisting of titanium dioxide, silicon dioxide, zinc oxide, and tungsten dioxide. The lens 31 and secondary light transmissive member 33 coated with the nanomaterial exhibit markedly enhanced UV absorption and thus demonstrate improvement in resistance to weathering, resistance to dust, and wear resistance.

The concentrated solar power module 30 further comprises a metal housing 36 and a diode 37. In general, conventional solar cell modules are low-power, and thus the low-power conventional solar cell modules are connected in series or in parallel to enhance performance thereof. Also, the concentrated solar power module 30 is equipped with the diode 37. The diode 37 is fixed in position to the base 341 and electrically connected to the solar cell 34 so as to prevent inverse voltage and circulating current which might otherwise damage the concentrated solar cell module 30. Therefore, the diode is a bypass diode or a blocking diode, depending on whether the solar cells or the solar-powered electricity generators are connected in series or in parallel.

Alternatively, the concentrated solar power module 30 shown in FIG. 3A is a plane-type solar power module comprising a solar cell, such as a silicon solar cell, a non-silicon solar cell, a thin-film solar cell, or a dye-sensitized solar cell.

Referring to FIG. 3B, the concentrated solar power module 30 comprises frames 38, 39 for coupling the lens 31, the light shield plate 32, and the solar-powered electricity generator together. The frames 38, 39 are provided with means for allowing internal components of the concentrated solar power module 30 to communicate with the exterior thereof so as to reduce wind resistance and vibration of the concentrated solar power module 30 typically installed outdoors, and for dispensing a detergent (not shown) into the frames 38, 39 during a cleaning process so as to cleanse the secondary light transmissive member 33 easily. For example, said means comprises a plurality of holes formed in the frames 38, 39 to penetrate the frames 38, 39.

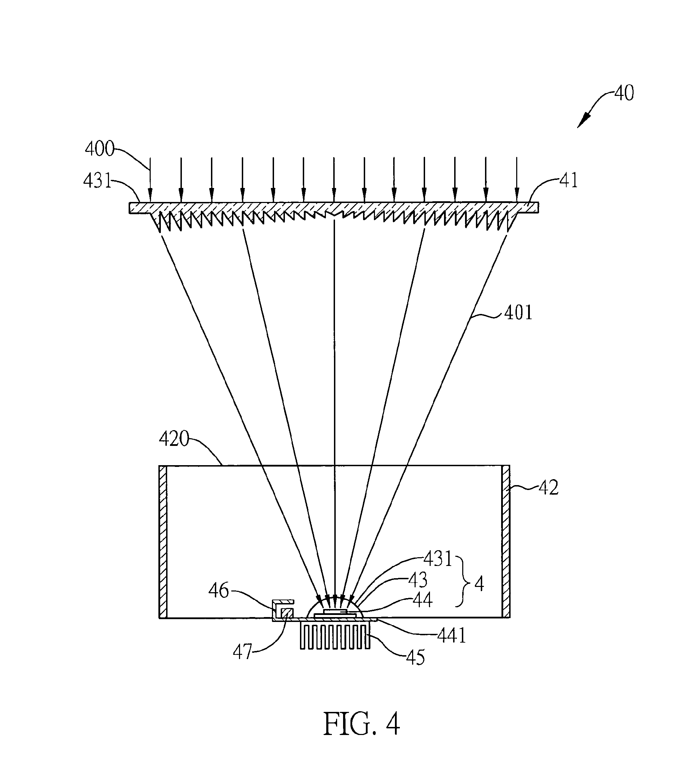

Referring to FIG. 4, which is a cross-sectional diagram showing a concentrated solar power module according to another aspect of the present invention, a concentrated solar power module 40 comprises a lens 41 coated with a self-cleaning material 431 thereon, a light shield plate 42, a secondary light transmissive member 43, a solar cell 44, a base 441, and a heat-dissipating element 45. While similar to the concentrated solar power module 30 in terms of the operational mechanisms, the concentrated solar power module 40 is installed with the light shield plate 42 at a different location. The light shield plate 42 is a frame body formed with an opening 420 for accommodating the solar-powered electricity generator therein so as to block side light and allow a plurality of light rays 401 concentrated by the lens 41 to be received by the solar cell 44.

A cleaning mechanism can be installed beside the concentrated solar power module or the lens thereof of the present invention, whether the lens is a Fresnel lens or a conventional simple lens. The cleaning mechanism cleanses the surface of the lens and enhances light penetration. The cleaning mechanism is an absorbent cleaning mechanism, a wiping cleaning mechanism, and a spraying cleaning mechanism.

Although the present invention has been described in detail by reference to the preferred embodiments and drawings thereof, it should be apparent to those skilled in the art that various adaptations and modifications of the present invention may be accomplished without departing from the spirit and the scope of the invention. Accordingly, it is to be understood that the detailed description and the accompanying drawings as set forth hereinabove are not intended to limit the scope of the present invention, which should be defined only by the following claims and their appropriately construed legal equivalents.

## Claims

1. A concentrated solar power module, comprising:
a lens configured to focus a plurality of light rays and coated with a self-cleaning material;
a light shield plate coupled to the lens, spaced apart from the lens by a predetermined distance, and formed with an opening selectively penetratable by a plurality of light rays thus concentrated by the lens;
a solar-powered electricity generator coupled to the light shield plate and yet spaced apart therefrom by a predetermined distance, the solar-powered electricity generator comprising a base, a secondary light transmissive member coupled to the base and coated with a self-cleaning material, and a solar cell mounted on the base, wherein an enclosed space is defined by the secondary light transmissive member and the base so as for the solar cell to be accommodated in the enclosed space in a hermetically sealed manner; and
a heat-dissipating element coupled to the solar-powered electricity generator for dissipating heat generated by the solar-powered electricity generator.

2. The concentrated solar power module of claim 1, wherein the lens is a Fresnel lens.

3. The concentrated solar power module of claim 1, wherein the self-cleaning material is a metal oxide for undergoing photocatalysis by ultraviolet (UV) irradiation.

4. The concentrated solar power module of claim 3, wherein the metal oxide is selected from the group consisting of titanium dioxide, tin oxide, tungsten trioxide, zinc oxide, and zirconium oxide.

5. The concentrated solar power module of claim 1, wherein the self-cleaning material prevents water and dust from adhering to a nanomaterial on the self-cleaning material.

6. The concentrated solar power module of claim 5, wherein the nanomaterial comprises nano-particles of one selected from the group consisting of titanium dioxide, silicon dioxide, zinc oxide, and tungsten dioxide.

7. The concentrated solar power module of claim 1, wherein the lens, the light shield plate and the solar-powered electricity generator are coupled together by at least a frame provided with means for allowing internal components of the concentrated solar power module to communicate with the exterior thereof so as to reduce wind resistance and vibration of the concentrated solar power module.

8. The concentrated solar power module of claim 1, further comprising a diode fixed in position to the base and electrically connected to the solar cell.

9. The concentrated solar power module of claim 1, wherein the light shield plate is formed with the opening corresponding in position to the solar-powered electricity generator and provided between the lens and the solar-powered electricity generator, allowing the light rays thus concentrated by the lens to penetrate the opening and reach the solar-powered electricity generator to thereby be received by the solar cell.

10. The concentrated solar power module of claim 1, wherein the light shield plate is a frame body formed with the opening and configured to accommodate the solar-powered electricity generator therein so as to block side light, allowing the light rays thus concentrated by the lens to be received by the solar cell.

11. The concentrated solar power module of claim 1, wherein a cleaning mechanism is installed beside the lens for cleansing a surface of the lens.

12. The concentrated solar power module of claim 11, wherein the cleaning mechanism is at least one selected from the group consisting of an absorbent cleaning mechanism, a wiping cleaning mechanism, and a sprayer.
